# EUROPÄISCHE PATENTSCHRIFT

(11) **EP 2 179 491 B1**
(45) Veröffentlichungstag und Bekanntmachung des Hinweises auf die Patenterteilung: **29.03.2017**
(21) Anmeldenummer: 08775298.6
(22) Anmeldetag: 23.07.2008
(51) Int. Cl.: H02K 11/33, H02K 9/06, H02K 5/20, H02K 1/20, H02K 5/15

(54) **ELEKTRISCHE MASCHINE MIT ÖFFNUNGEN IM LAGERSCHILDUNTERTEIL**
ELECTRICAL MACHINE WITH OPENINGS IN THE BEARING SHIELD
MOTEUR ÉLECTRIQUE À OUVERTURES PRATIQUÉES DANS LA PARTIE INFÉRIEURE DU FLASQUE

(30) Priorität: 25.07.2007 DE 102007034741
(43) Veröffentlichungstag der Anmeldung: 28.04.2010
(73) Patentinhaber: Siemens Aktiengesellschaft, 80333 München (DE)
(72) Erfinder: BRACH, Karsten, 13589 Berlin (DE); MEYER, Christian, 13591 Berlin (DE); VOGELEY, Peter, 14612 Falkensee (DE); WILCKE, Ralf, 13351 Berlin (DE)
(86) Internationale Anmeldenummer: PCT/EP2008/059628
(87) Internationale Veröffentlichungsnummer: WO 2009/013302

(56) Entgegenhaltungen:
- EP-A- 0 194 433
- WO-A-2004/112220

## Beschreibung

Die vorliegende Erfindung betrifft eine elektrische Maschine mit einem Glockenläufer, einem Stator, der radial außerhalb oder innerhalb des Glockenläufers angeordnet ist, mehreren Wechselrichtern (Stellern) und/oder mindestens einer Steuereinrichtung, die im Inneren des Glockenläufers angeordnet sind und zur Ansteuerung des Stators oder der Wechselrichter dienen, und einem Lagerschildteil, an dem der Glockenläufer gelagert ist. Insbesondere betrifft die vorliegende Erfindung umrichtergespeiste Drehfeldmaschinen mit elektronischem Steller zum Antrieb von U-Booten.

Umrichtergespeiste Drehfeldmaschinen insbesondere für den Propulsionsantrieb eines U-Boots sind beispielsweise aus den Druckschriften EP 0 194 433 B1 und WO 2004/068694 A1 bekannt. Zur Erzielung eines kompakten Antriebs sind die Läufer als Glockenläufer ausgestaltet. Der Innenraum des Glockenläufers wird zur Aufnahme von Wechselrichtern, die zur Leistungseinspeisung für die Statorwicklungen dienen, verwendet. Die Wechselrichter sind in einem Wechselrichterhaltegerüst im Inneren des Glockenläufers befestigt. An der offenen Seite des Läufers befindet sich ein Lagerschild, das im oberen Bereich mit Serviceöffnungen versehen ist. Diese Öffnungen ermöglichen den stirnseitigen Zugang zu Abschnitten des Stellers. Damit der Zugang zu allen Stellern gewährleistet ist, ist der Ständer samt Steller im Ständergehäuse drehbar gelagert. Eine derartige Lagerung ist jedoch verhältnismäßig aufwändig zu realisieren.

Um diesen Aufwand der Drehbarkeit des Ständers und der Wechselrichter nicht zu betreiben, können die Wechselrichter auf konventionelle Weise auch außerhalb der Maschine lokalisiert sein. Dies führt jedoch gegenüber der erstgenannten Lösung zu einem erheblich höheren Platzbedarf sowie einer wesentlich schlechteren elektromagnetischen Verträglichkeit und einer erhöhten Streufeldabstrahlung. Bei der Lösung mit den Wechselrichtern innerhalb des Antriebs verlaufen nämlich auch die Kabel von den Wechselrichtern zu dem Stator innerhalb der Maschine bzw. innerhalb des Gehäuses, so dass elektromagnetische Abstrahlungen ohne zusätzliche Maßnahmen deutlich geschirmt werden.

Aus der Druckschrift WO 2004/112220 A1 ist ein Glockenläufermotor bekannt, bei dem zwischen der Läufernabe und der Läuferwelle ein Zwischenraum ausgebildet ist, in welchem Antriebskomponenten untergebracht sind. Die Antriebskomponenten umgeben ringförmig die Läuferwelle und sind deshalb vorteilhafterweise in einzelne Ringsegmente unterteilt. Sie können durch im Lagerschild vorgesehene Durchlässe ausgewechselt werden.

Die Aufgabe der vorliegenden Erfindung besteht somit darin, eine elektrische Maschine der eingangs genannten Art dahingehend weiterzubilden, dass sie bei vermindertem Aufwand sehr servicefreundlich ist.

Erfindungsgemäß wird die Aufgabe gelöst durch eine elektrische Maschine insbesondere zum Antrieb von U-Booten mit einem Glockenläufer, einem Stator, der radial außerhalb oder innerhalb des Glockenläufers angeordnet ist, mehreren Wechselrichtern und/oder mindestens einer Steuereinrichtung, die im Inneren des Glockenläufers angeordnet sind und zur Ansteuerung des Stators oder der Wechselrichter dienen, und einem Lagerschildunterteil an dem der Glockenläufer gelagert ist, wobei das Lagerschildunterteil eine oder mehrere Öffnungen aufweist, so dass durch die/jede Öffnung der axial dahinter angeordnete Wechselrichter oder die axial dahinter angeordnete Steuereinrichtung aus dem Glockenläufer entnehmbar ist, und das Läuferschildunterteil weist eine teilkreisförmige, insbesondere halbkreisförmige Außenkontur auf. Damit ist die Welle auch für Servicearbeiten nach unten hinreichend gestützt. Das Lagerschildoberteil kann dann für Servicearbeiten demontiert werden.

In vorteilhafter Weise kann somit auf die Drehbarkeit der Statoraktivteile sowie der angeschlossenen Wechselrichter verzichtet werden. Der/die Wechselrichter sind dennoch auch im Unterteil der elektrischen Maschine austauschbar, obwohl das Lagerschildunterteil, auf dem der Läufer gelagert ist, nicht demontiert werden kann. Das Lagerschildoberteil hingegen ist unkritisch und kann demontierbar oder ebenso mit Öffnungen gestaltet werden.

Vorzugsweise besitzen die Öffnungen jeweils im Wesentlichen die Kontur des zugeordneten dahinter befindlichen Wechselrichters oder der dahinter befindlichen Steuereinrichtung. Jede Öffnung ist dabei natürlich etwas größer als die dahinterliegende Komponente, so dass die Komponente durch die jeweilige Öffnung ausgetauscht werden kann.

Darüber hinaus können in dem Glockenläufer Radialventilatoren zur Belüftung der Wechselrichter angeordnet sein. Alternativ oder zusätzlich kann der Wechselrichter eine Flüssigkeitskühlung aufweisen. Derartige Kühlungen führen zu einem erhöhten Wirkungsgrad der elektrischen Maschine.

Ferner kann der Glockenläufer mit Permanentmagneten bestückt sein. Auf diese Weise lässt sich ein verlustarmer Läufer realisieren.

Entsprechend einer anderen Weiterbildung können die Pole der elektrischen Maschine in axialer Richtung segmentiert sein. Auch dies führt zu einer Reduzierung der Verluste.

Entsprechend einer weiteren Ausführungsform weist das Joch des Stators eine Flüssigkeitskühlung auf. Auch können an dem Glockenläufer axial angeordnete Lüfterflügel zum Belüften der Statorwickelköpfe vorgesehen sein. Diese Maßnahmen führen ebenso zu einer Verbesserung des Wirkungsgrads der elektrischen Maschine.

Weiterhin kann in dem Glockenläufer eine Ringverschienung mit zusätzlich weichmagnetischen Massen zur Stromversorgung der Wechselrichter angeordnet sein. Die weichmagnetischen Massen gewährleisten eine induktionsarme Realisierung der Stromversorgung.

Außerdem können Dämpfungsmassen zum akustischen Dämpfen an den Wechselrichtern, dem Glockenläufer, dem Stator und/oder dem Lagerschildunterteil angeordnet sein. Hierdurch lassen sich akustische Schwingungen, die von unerwünschten Anregungen erzeugt werden, weitestgehend reduzieren.

Entsprechend einer weiteren Ausführungsform ist vorgesehen, dass die Wechselrichter durch ein mantelgekühltes Haltegerüst im Glockenläufer gehalten und gekühlt werden. Dies führt zu einer wirksamen Wärmeabfuhr von den Wechselrichtern und verleiht dem Haltegerüst eine doppelte Funktionalität.

Innerhalb des Glockenläufers kann erfindungsgemäß auch eine gegebenenfalls segmentierte Steuereinrichtung angeordnet sein, die einen Drehzahlüberwachungsrechner und/oder eine Pumpensteuereinheit umfasst. Hierdurch kann weiterer Platz eingespart und der in der elektrischen Maschine befindliche Raum besser ausgenutzt werden.

Die vorliegende Erfindung ist anhand der beigefügten Zeichnungen näher erläutert, in denen zeigen:
- FIG 1: ein Lagerschildunterteil gemäß der vorliegenden Erfindung;
- FIG 2: eine erfindungsgemäße elektrische Maschine mit abgenommenem Lagerschildoberteil; und
- FIG 3: einen Axialschnitt durch das Oberteil einer erfindungsgemäßen elektrischen Maschine mit spezieller Kühlung.

Die nachfolgend näher geschilderten Ausführungsbeispiele stellen bevorzugte Ausführungsformen der vorliegenden Erfindung dar.

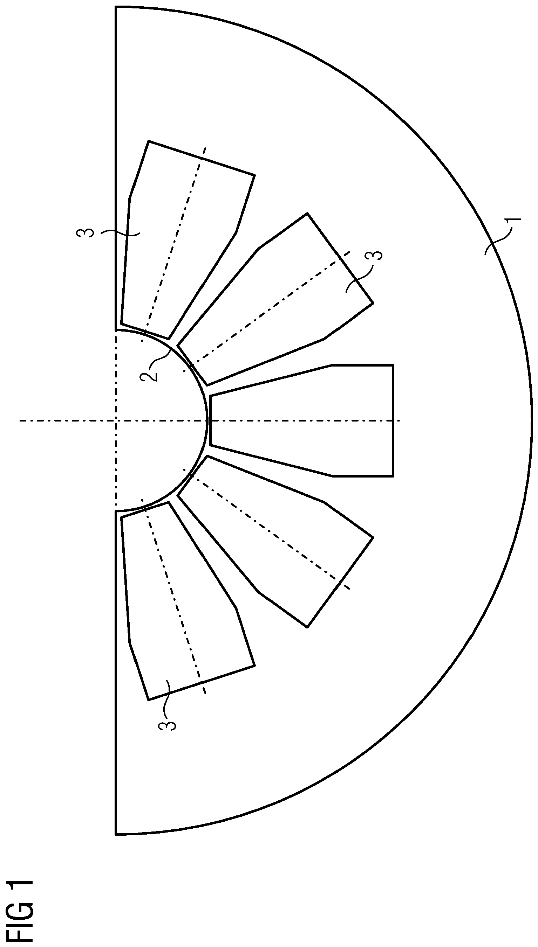

Das in FIG 1 dargestellte Lagerschildunterteil 1 besitzt im Wesentlichen eine halbkreisförmige Außenkontur mit im Axialbereich ausgeschnittenem Halbkreis 2 zur Lagerung der Maschinenwelle. In Umfangsrichtung gleichmäßig verteilt sind wabenförmige Öffnungen 3 vorgesehen. Die Öffnungen 3 sind hier sechseckig mit entsprechenden Verjüngungen zur Mitte hin ausgebildet.

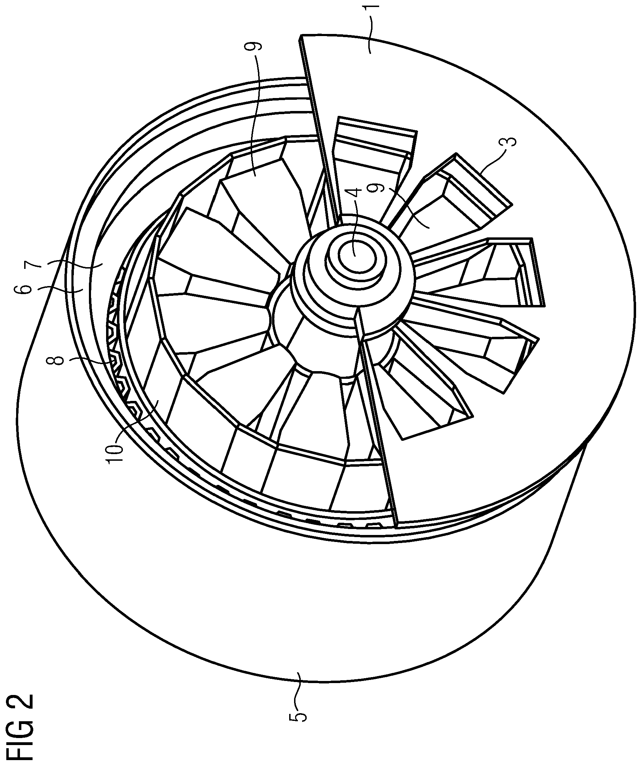

In FIG 2 ist eine erfindungsgemäße umrichtergespeiste Drehfeldmaschine mit elektronischem Steller schematisch dargestellt. Mit dem Lagerschildunterteil 1, das die Öffnungen 3 besitzt, ist die Welle 4 der elektrischen Maschine gelagert. Ein rohrförmiges Gehäuse 5 umgibt einen hohlzylindrischen Stator 6. Ein Glockenläufer 7 ist an der A-Seite (Abtriebsseite der Maschine) drehfest mit der Welle 4 verbunden. Er weist Permanentmagnete 8 auf. Im Inneren des Glockenläufers 7 befindet sich ein zylinderförmiger Raum der für die Wechselrichter 9 genutzt wird. Im vorliegenden Fall handelt es sich um zehn Wechselrichter bzw. Wechselrichtermodule. Im Fall eines Wechselrichtermoduls können beispielsweise zwei oder mehr Einphasenwechselrichter zu einem Modul zusammengefügt sein. Mit den Wechselrichtern 9 (gegebenenfalls gruppiert zu Wechselrichtermodulen) können die Stränge des Stators 6 einzeln angesteuert werden. Die Wechselrichter 9 werden durch ein Wechselrichterhaltegerüst 10 im Inneren des Glockenläufers 7 gehalten. Der Übersichtlichkeit halber wurde auf die Darstellung von Stegen zwischen den einzelnen Wechselrichtern 9 verzichtet. Diese sind aber in der Regel notwendig, um die Wechselrichter im Maschineninnenraum ausreichend zu stabilisieren.

Zum Austausch bzw. zur Reparatur der Wechselrichter 9 können diese aus dem Oberteil der Maschine leicht entnommen werden, wenn das Lagerschildoberteil demontiert ist. Die Wechselrichter 9 im unteren Teil der Maschine können durch die ihnen einzeln zugeordneten Öffnungen 3 ebenfalls aus ihrem Haltegerüst 10 entnommen werden. Aufgrund der Öffnungen ist es nicht notwendig, den Stator 6 samt dem Wechselrichterhaltegerüst 10 mit den Wechselrichtern 9 zu drehen, um letztere aus der Maschine zu demontieren. Vielmehr ist jeder Wechselrichter 9 bzw. jedes Wechselrichtermodul ohne Weiteres direkt zugänglich.

Zur Verbesserung der Belüftung der Wechselrichter 9 im Glockenläufer 7 sind in diesem in FIG 2 nicht dargestellte Radialventilatoren angeordnet. Sie sorgen für einen radial gerichteten Luftstrom um die Wechselrichter 9. Zusätzlich sind die Wechselrichter 9 mit einer Wasserkühlung (ebenfalls nicht dargestellt) versehen, um möglichst kleine Aggregate realisieren zu können.

Vorzugsweise ist die Maschine permanent erregt, um eine wirkungsgrad-optimierte Maschine ohne hohe Verluste des Läufers zu erhalten. Zur Verminderung der Verluste werden außerdem die Magnete bzw. Pole segmentiert.

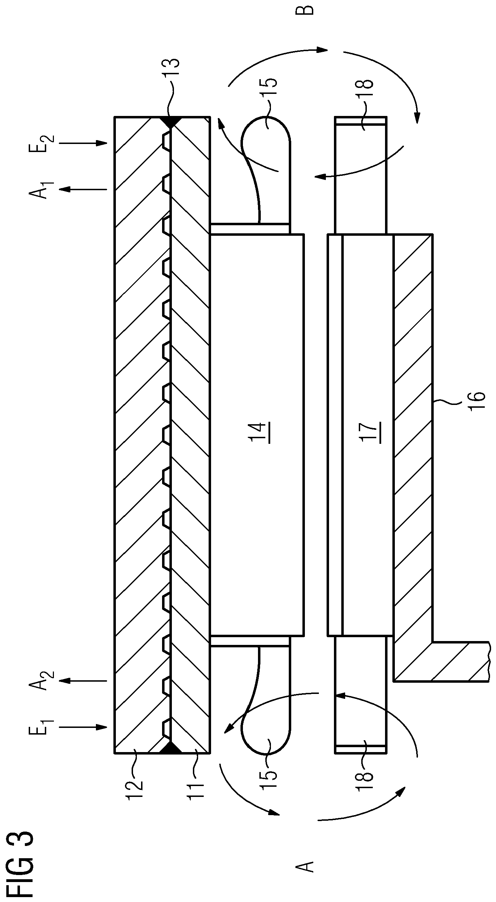

Um eine geräuscharme und effektive Kühlung des übrigen Motors zu realisieren wird beispielsweise das Ständerjoch mit Wasser gekühlt. Eine derartige Kühlung (Kühlring mit axialverlaufenden Kühlbohrungen) ist jedoch sehr aufwändig. Zum einen sind lange axiale Kühlbohrungen nur schwierig zu realisieren und zum andern sind die Umlenkungen der Kühlrohre an den Stirnseiten stets Punkte erhöhter Undichtigkeitsgefahr. Daher ist es von besonderem Vorteil, das Statorjoch auf die in FIG 3 dargestellte Weise zu kühlen. Der Kühlring besteht hier aus einem inneren Ring 11 und einem äußeren Ring 12. Der äußere Ring 12 besitzt eine Art mehrgängiges "Trapezinnengewinde". Außerdem ist er auf den inneren Ring 11 geschrumpft und mit ihm durch Schweißnähte 13 verschweißt. Zwischen den beiden Ringen ergeben sich somit mehrere parallel verlaufende wendelförmige Kühlkanäle. Bei einem zweigängigen Trapezinnengewinde wird in den Eingang E₁ des ersten Kanals, der sich auf der A-Seite der elektrischen Maschine befindet, Kühlwasser eingepumpt, fließt durch den wendelförmigen Kühlkanal und verlässt an der B-Seite am Ausgang A₁ das Statorjoch. Auf der B-Seite wird das Kühlmittel in den Eingang E₂ gepumpt, durchfließt den zweiten Kühlkanal in Richtung A-Seite und verlässt dort den Kühlring am Ausgang A₂. Durch die gegenläufige Kühlung wird das Statorjoch an der A-Seite ebenso gekühlt wie an der B-Seite. Außerdem kann auf Umlenkkammern verzichtet werden, so dass die Gefahr der Undichtigkeit vermindert ist. Ferner erfüllt die Mehrgängigkeit die Redundanzforderungen bezüglich des Ausfalls eines Systems. Mittels Schnellkupplungen und Flanschen oder festen Verschraubungen kann die Kühlung des Stators an ein externes oder internes Kühlsystem angeschlossen werden.

Radial innerhalb des Kühlrings 11,12 befindet sich das Stator-aktivteil 14 mit den Wickelköpfen 15. Innerhalb des Statoraktivteils 14 befindet sich die Läuferglocke 16 mit dem Läuferaktivteil 17. An dem Läuferaktivteil 17 oder der Läuferglocke 16 sind axial angeordnete Lüfterflügel 18 sowohl an der A- als auch an der B-Seite vorgesehen, um die Wickelköpfe 15 des Stators zu ventilieren. Die Lüfterflügel 18 sorgen für den mit Pfeilen in FIG 3 eingezeichneten Lüftungsstrom um die Wickelköpfe 15.

Für die Stromversorgung der Wechselrichter ist in dem Wechselrichterhaltegerüst eine induktivitätsarme Ringverschienung vorgesehen, die entsprechende weichmagnetische Massen auf der Schiene enthält. Auch der Signalverteiler ist ringförmig angeordnet und befindet sich zur Ansteuerung der um die Welle 4 angeordneten Wechselrichter 9 axial zwischen dem Lagerschild und dem Wechselrichterhaltegerüst 10. Die Wechselrichter sind vorzugsweise so ausgelegt, dass sie sowohl mit Gleichstrom als auch über Gleichrichter mit Wechselstrom gespeist werden können.

Da die Geometrie der Aktivteile der elektrischen Maschine nie vollkommen auf die Form der elektrischen Anregung abgestimmt sein kann, kommt es zwangsläufig zu ungewollten Schwingungen der Komponenten der elektrischen Maschine. Diese werden durch speziell vorgesehene "Akustikmassen" an den Maschinenkomponenten gedämpft. Um stärkere Schwankungen des Motors in einem Boot zu vermeiden, können außerdem zusätzliche Stützen oberhalb der Motorachse in dem Boot angebracht werden.

Die Kühlung der Wechselrichter kann ferner dadurch unterstützt werden, dass das Wechselrichterhaltegerüst mantelgekühlt ist. Es ist also zumindest in Teilen mehrwandig ausgebildet, so dass Kühlmittel hindurchgeführt werden kann.

Bei einer alternativen Ausführungsform der erfindungsgemäßen elektrischen Maschine werden die Wechselrichter in der oberen Hälfte der Maschine angeordnet, um einen leichteren Zugang zu gewährleisten. In der unteren Hälfte werden dann andere Steuerelemente wie Drehzahlüberwachungsrechner, Pumpensteuerelemente und dergleichen angeordnet. Für diesen Fall sind dann die Öffnungen im Lagerschildunterteil entsprechend zu gestalten.

## Patentansprüche

1. Elektrische Maschine insbesondere zum Antrieb von U-Booten mit
- einem Glockenläufer (7),
- einem Stator (6), der radial außerhalb oder innerhalb des Glockenläufers (7) angeordnet ist,
- mehreren Wechselrichtern (9) und/oder mindestens einer Steuereinrichtung, die im Inneren des Glockenläufers (7) angeordnet sind und zur Ansteuerung des Stators (6) oder der Wechselrichter (9) dienen, und
- einem Lagerschildunterteil (1), an dem der Glockenläufer gelagert ist,
wobei
- das Lagerschildunterteil (1) eine oder mehrere Öffnungen (3) aufweist, so dass durch die/jede Öffnung (3) der axial dahinter angeordnete Wechselrichter (9) oder die axial dahinter angeordnete Steuereinrichtung aus dem Glockenläufer (7) entnehmbar ist, und
- das Lagerschildunterteil (1) eine teilkreisförmige Au**ßenkontur** aufweist.

2. Elektrische Maschine nach Anspruch 1, wobei das Lagerschildunterteil (1) mehrere Öffnungen (3) in Umfangsrichtung verteilt besitzt, die jeweils im Wesentlichen die Kontur des zugeordneten, dahinter befindlichen Wechselrichters (9) in axialer Projektion besitzen.

3. Elektrische Maschine nach einem der vorhergehenden Ansprüche, wobei in dem Glockenläufer (7) Radialventilatoren zur Belüftung der Wechselrichter (9) angeordnet sind.

4. Elektrische Maschine nach einem der vorhergehenden Ansprüche, wobei die Wechselrichter (9) eine Flüssigkeitskühlung aufweisen.

5. Elektrische Maschine nach einem der vorhergehenden Ansprüche, wobei der Glockenläufer (7) Permanentmagnete (8) trägt.

6. Elektrische Maschine nach einem der vorhergehenden Ansprüche, wobei die Pole der elektrischen Maschine in axialer Richtung segmentiert sind.

7. Elektrische Maschine nach einem der vorhergehenden Ansprüche, wobei das Joch (11, 12) des Stators eine Flüssigkeitskühlung aufweist, und dazu der Stator von einem Kühlring mit einem inneren Ring 11 und einem äußeren Ring 12 umgeben ist, wobei der äußere Ring 12 auf den inneren Ring 11 aufgeschrumpft ist und zwischen beiden Ringen ein mehrkanaliges, wendelförmiges Kühlkanalsystem gebildet ist.

8. Elektrische Maschine nach einem der vorhergehenden Ansprüche, wobei der Glockenläufer axial angeordnete Lüfterflügel (18) zum Belüften der Statorwickelköpfe (15) aufweist.

9. Elektrische Maschine nach einem der vorhergehenden Ansprüche, wobei in dem Glockenläufer (7) eine Ringverschienung mit zusätzlichen weichmagnetischen Massen zur Stromversorgung der Wechselrichter (9) angeordnet ist.

10. Elektrische Maschine nach einem der vorhergehenden Ansprüche, wobei Dämpfungsmassen zum akustischen Dämpfen an den Wechselrichtern (9), dem Glockenläufer (7), dem Stator (6) und/oder dem Lagerschildunterteil (1) angeordnet sind.

11. Elektrische Maschine nach einem der vorhergehenden Ansprüche, wobei die Wechselrichter (9) durch ein mantelgekühltes Haltegerüst im Glockenläufer (7) gehalten und gekühlt werden.

12. Elektrische Maschine nach einem der vorhergehenden Ansprüche, wobei die mindestens eine Steuereinrichtung einen Drehzahlüberwachungsrechner oder eine Pumpensteuereinheit umfasst.

## Claims

1. Electric machine, in particular for driving submarines, having
- a bell-type rotor (7),
- a stator (6), which is arranged radially outside or inside the bell-type rotor (7),
- a plurality of inverters (9) and/or at least one control facility, which are arranged within the bell-type rotor (7) and serve to actuate the stator (6) or the inverter (9), and
- a bearing shield lower part (1), on which the bell-type rotor is mounted,
wherein
- the bearing shield lower part (1) has one or more apertures (3), so that the inverter (9) arranged axially behind or the control facility arranged axially behind can be removed from the bell-type rotor (7) through the/each aperture (3), and
- the bearing shield lower part (1) has an outer contour in the shape of a pitch circle.

2. Electric machine according to claim 1, wherein the bearing shield lower part (1) possesses a plurality of apertures (3) spaced along the circumferential direction, which in each case essentially possess the contour of the associated inverter (9) arranged behind in the axial projection.

3. Electric machine according to one of the preceding claims, wherein radial fans are arranged in the bell-type rotor (7) to ventilate the inverters (9).

4. Electric machine according to one of the preceding claims, wherein the inverter (9) has liquid cooling.

5. Electric machine according to one of the preceding claims, wherein the bell-type rotor (7) supports permanent magnets (8).

6. Electric machine according to one of the preceding claims, wherein the poles of the electric machines are segmented in the axial direction.

7. Electric machine according to one of the preceding claims, wherein the yoke (11, 12) of the stator has liquid cooling, and in addition the stator is surrounded by a cooling ring with an inner ring 11 and an outer ring 12, wherein the outer ring 12 is shrunk onto the inner ring 11 and a multi-channel, coil-shaped cooling channel system is formed between the two rings.

8. Electric machine according to one of the preceding claims, wherein the bell-type rotor has axially arranged fan blades (18) for ventilating the stator winding heads (15).

9. Electric machine according to one of the preceding claims, wherein a ring-type busbar with additional soft-magnetic masses is arranged in the bell-type rotor (7) for supplying power to the inverters (9).

10. Electric machine according to one of the preceding claims, wherein damping masses are arranged on the inverters (9), the bell-type rotor (7), the stator (6) and/or the bearing shield lower part (1) for acoustic damping.

11. Electric machine according to one of the preceding claims, wherein the inverters (9) are retained and cooled by a jacket-cooled retaining framework in the bell-type rotor (7).

12. Electric machine according to one of the preceding claims, wherein the at least one control facility comprises a rotational speed monitoring computer or a pump control unit.

## Revendications

1. Moteur électrique, notamment pour la propulsion de sous-marins comprenant
- un induit ( 7 ) en cloche,
- un stator ( 6 ) monté radialement à l'extérieur ou à l'intérieur de l'induit ( 7 ) en cloche,
- plusieurs onduleurs ( 9 ) et/ou au moins un dispositif de commande, qui sont mis à l'intérieur de l'induit ( 7 ) en cloche et qui servent à commander le stator ( 6 ) ou les onduleurs ( 9 ) et
- une partie ( 1 ) inférieure de flasque sur laquelle l'induit en cloche est monté,
dans lequel
- la partie ( 1 ) inférieure de flasque a une ouverture ou plusieurs ouvertures ( 3 ), de manière à pouvoir retirer de l'induit ( 7 ) en cloche, par l'ouverture ou par chaque ouverture ( 3 ), l'onduleur ( 9 ) disposé derrière axialement ou le dispositif de commande disposé derrière axialement et
- la partie ( 1 ) inférieure de flasque a un contour extérieur en forme de partie de cercle.

2. Moteur électrique suivant la revendication 1, dans lequel la partie ( 1 ) inférieure de flasque a plusieurs ouvertures ( 3 ) réparties dans la direction périphérique, qui ont chacune sensiblement, en projection axiale, le contour de l'onduleur ( 9 ) associé se trouvant derrière.

3. Moteur électrique suivant l'une des revendications précédentes, dans lequel des ventilateurs à flux radial de ventilation des onduleurs ( 9 ) sont disposés dans l'induit ( 7 ) en cloche.

4. Moteur électrique suivant l'une des revendications précédentes, dans lequel les onduleurs ( 9 ) ont un refroidissement par du liquide.

5. Moteur électrique suivant l'une des revendications précédentes, dans lequel l'induit ( 7 ) en cloche porte des aimants ( 8 ) permanents.

6. Moteur électrique suivant l'une des revendications précédentes, dans lequel les pôles du moteur électrique sont segmentés dans la direction axiale.

7. Moteur électrique suivant l'une des revendications précédentes, dans lequel la culasse ( 11, 12 ) du stator a un refroidissement par du liquide et, à cet effet, le stator est entouré d'un anneau de refroidissement ayant un anneau ( 11 ) intérieur et un anneau ( 12 ) extérieur, l'anneau ( 12 ) extérieur étant rétreint sur l'anneau ( 11 ) intérieur et un système de conduits de refroidissement hélicoïdal à plusieurs conduits est formé entre les deux anneaux.

8. Moteur électrique suivant l'une des revendications précédentes, dans lequel l'induit en cloche a, pour ventiler les têtes ( 15 ) de bobine du stator, des pales ( 18 ) de ventilateur disposées axialement.

9. Moteur électrique suivant l'une des revendications précédentes, dans lequel il est disposé, pour l'alimentation en courant des onduleurs ( 9 ), dans l'induit ( 7 ) en cloche, un rail annulaire ayant des masselottes à magnétisme doux supplémentaires.

10. Moteur électrique suivant l'une des revendications précédentes, dans lequel des masselottes d'atténuation acoustique sont montées sur les onduleurs ( 9 ), l'induit ( 7 ) en cloche, le stator ( 6 ) et/ou la partie ( 1 ) inférieure du flasque.

11. Moteur électrique suivant l'une des revendications précédentes, dans lequel les onduleurs ( 9 ) sont maintenus et refroidis dans l'induit ( 7 ) en cloche par une ossature de maintien refroidie par chemise.

12. Moteur électrique suivant l'une des revendications précédentes, dans lequel le au moins un dispositif de commande comprend un ordinateur de contrôle de la vitesse de rotation ou une unité de commande de pompe.
